# EUROPÄISCHE PATENTANMELDUNG

(11) **EP 3 869 689 A1**
(43) Veröffentlichungstag der Anmeldung: **25.08.2021**
(21) Anmeldenummer: 20158835.7
(22) Anmeldetag: 21.02.2020
(51) Int. Cl.: H03F 1/02, H02M 3/335, H03F 1/52, H03F 3/217

(54) **VERSTÄRKERSCHALTUNG UND VERFAHREN ZU DEREN BETRIEB**

(71) Anmelder: Siemens Schweiz AG, 8047 Zürich (CH)
(72) Erfinder: Waldmeier, Christoph, 8854 Siebenen (CH)
(74) Vertreter: Maier, Daniel Oliver

(57) **Zusammenfassung**

Angegeben werden eine Verstärkerschaltung (10) mit einer Eingangsseite (14), einer Ausgangsseite (16) und einem die Eingangsseite (14) mit der Ausgangsseite (16) koppelnden Übertrager (12) sowie mit Schaltern (S1, S2) auf der Eingangsseite (14) und Schaltern (S3, S4) beidseitig des Übertragers (12) auf der Ausgangsseite (16), wobei die Verstärkerschaltung (10) auf der Ausgangsseite (16) beidseitig des Übertragers (12) und elektrisch parallel zu den dortigen Schaltern (S3, S4) jeweils eine aktive Klemmschaltung (30, 32) aufweist, sowie ein Verfahren zu deren Betrieb, wobei jede aktive Klemmschaltung (30, 32) einen Schalter (S5, S6) umfasst, wobei der Schalter (S5, S6) jeder aktiven Klemmschaltung (30, 32) grundsätzlich offen ist und bei offenem Schalter (S5, S6) elektrische Energie aus der umgebenden Verstärkerschaltung (10) in den Kondensator (Cₛ) der aktiven Klemmschaltung (30, 32) geladen wird und wobei der Schalter (S5, S6) jeder aktiven Klemmschaltung (30, 32) getaktet geschlossen wird und bei geschlossenem Schalter (S5, S6) in dem Kondensator (Cₛ) gespeicherte elektrische Energie in die umgebende Verstärkerschaltung (10) zurückgespeist wird.

## Beschreibung

Die Erfindung betrifft eine Verstärkerschaltung, zum Beispiel eine Verstärkerschaltung wie sie aus der WO 2018/086899 A1 bekannt ist, und im Weiteren ein Verfahren zu deren Betrieb.

Die bekannte Verstärkerschaltung umfasst einen Übertrager mit gekoppelten Induktivitäten, nämlich einer eingangsseitigen Induktivität und einer ausgangsseitigen Induktivität. Die eingangsseitige Induktivität ist Teil einer Eingangsseite der Verstärkerschaltung mit eingangsseitigen Schaltern. Die ausgangsseitige Induktivität ist Teil einer Ausgangsseite der Verstärkerschaltung mit ausgangsseitigen Schaltern.

Die grundsätzliche Funktion der Verstärkerschaltung der WO 2018/086899 A1 lässt sich kurz wie folgt beschreiben:
Ein aufgrund einer Eingangsspannung (Eingangsgleichspannung) resultierender Stromfluss durch die eingangsseitige Induktivität bewirkt eine Magnetisierung der ausgangsseitigen Induktivität und dies wiederum bewirkt einen von der ausgangsseitigen Induktivität ausgehenden Stromfluss. Der Stromfluss durch die eingangsseitige Induktivität und damit in Folge auch durch die ausgangsseitige Induktivität wird als getakteter Stromfluss gezielt mittels einer getakteten Ansteuerung, zum Beispiel einer pulsweitenmodulierten Ansteuerung, der eingangsseitigen Schalter erzeugt. Diese getaktete Ansteuerung schaltet die an der Verstärkerschaltung anliegende Eingangsspannung auf diese und auf deren Übertrager auf. Auf der Ausgangsseite ergibt sich damit ein getakteter Stromfluss und es ergeben sich entsprechend getaktete Spannungspulse (ausgangsseitige Spannungspulse). Mittels einer getakteten, mit der Ansteuerung der eingangsseitigen Schalter korrelierten Ansteuerung der ausgangsseitigen Schalter werden die ausgangsseitig erzeugten Spannungspulse zu einer Ausgangsspannung (Ausgangsgleichspannung) kombiniert. Die Verstärkerschaltung setzt damit - aufgrund des Übertragers mit galvanischer Trennung zwischen der Eingangsseite und der Ausgangsseite - die Eingangsspannung in die Ausgangsspannung um. Regelmäßig ist die Ausgangsspannung höher als die Eingangsspannung. Grundsätzlich ist aber (abhängig vom Übersetzungsverhältnis des Übertragers) auch eine Ausgangsspannung unterhalb der Eingangsspannung möglich. Die Ausgangsspannung steht zur Versorgung einer unmittelbar oder mittelbar an die Verstärkerschaltung angeschlossenen Last zur Verfügung.

Problematisch bei einer solchen oder ähnlichen Verstärkerschaltung, also einer Verstärkerschaltung, welche auf einem Übertrager mit Induktivitäten zur Umsetzung der jeweiligen Eingangsspannung in eine Ausgangsspannung basiert, sind beim Betrieb resultierende Spannungsspitzen aufgrund einer sogenannten Streuinduktivität (leakage inductance), wobei die Spannungsspitzen entstehen, weil der Strom in der Induktivität weiterfließen will. Die Streuinduktivität beschreibt jenen Induktivitätsanteil, welcher bei magnetisch gekoppelten Systemen durch den Streufluss gebildet wird, und die Streuinduktivität der ausgangsseitigen Wicklung ergibt sich aufgrund einer fehlenden magnetischen Kopplung mit der eingangsseitigen Wicklung. Spannungsspitzen aufgrund der Streuinduktivität treten sowohl auf der Eingangsseite wie auch auf der Ausgangsseite einer solchen Verstärkerschaltung auf. Die hier vorgeschlagene Neuerung befasst sich mit den ausgangsseitigen Spannungsspitzen.

Solche ausgangsseitigen Spannungsspitzen können zu einer Gefährdung ausgangsseitiger Bauteile (Bauteile der Verstärkerschaltung) führen. Einer Schädigung der von solchen Spannungsspitzen betroffenen Bauteile hat man bisher mittels einer ausreichenden Dimensionierung der Bauteile zu begegnen versucht. Alternativ kommt auch ein Verbrauch der elektrischen Energie der Spannungsspitzen an einem Widerstand in Betracht, wobei der Widerstand die Spannungsspitzen dämpft, so dass Bauteile mit einer tieferen Spannungsfestigkeit gewählt werden können. Die elektrische Energie wird dann in Wärme umgewandelt. Beide Möglichkeiten sind nicht optimal. Die vorgenannte "ausreichende Dimensionierung" ist regelmäßig eine Überdimensionierung, was zu erhöhten Bauteilkosten und üblicherweise auch zu einem erhöhten Raumbedarf der Bauteile und damit der Verstärkerschaltung insgesamt führt. Bei einem Verbrauch der Energie der Spannungsspitzen an einem Widerstand steht die verbrauchte Energie für die Versorgung einer an die Verstärkerschaltung angeschlossenen Last nicht mehr zu Verfügung und entsprechend ergibt sich ein verringerter Wirkungsgrad der Verstärkerschaltung.

Eine Aufgabe der vorliegenden Erfindung besteht davon ausgehend darin, eine verbesserte Verstärkerschaltung anzugeben, insbesondere eine Verstärkerschaltung, welche solche Nachteile vermeidet.

Diese Aufgabe wird erfindungsgemäß mittels einer Verstärkerschaltung mit den Merkmalen des Anspruchs 1 gelöst.

Die Verstärkerschaltung umfasst - in grundsätzlich an sich bekannter Art und Weise - eine Eingangsseite, eine Ausgangsseite und einen die Eingangsseite mit der Ausgangsseite koppelnden Übertrager. Die Verstärkerschaltung umfasst des Weiteren - in ebenfalls grundsätzlich an sich bekannter Art und Weise - Schalter auf der Eingangsseite und auf der Ausgangsseite, wobei zumindest auf der Ausgangsseite die Verstärkerschaltung die dortigen Schalter beidseitig des Übertragers aufweist, also in einem ersten und einem zweiten, jeweils vom Übertrager ausgehenden Ausgangszweig. Die hier vorgeschlagene Neuerung sieht vor, dass die Verstärkerschaltung auf der Ausgangsseite beidseitig des Übertragers und elektrisch parallel zu den dortigen Schaltern - also einerseits elektrisch parallel zu dem Schalter des ersten Ausgangszweigs und andererseits elektrisch parallel zu dem Schalter des zweiten Ausgangszweigs - jeweils eine aktive Klemmschaltung aufweist. Diese beiden Klemmschaltungen werden im Folgenden zur Unterscheidung als erste Klemmschaltung und zweite Klemmschaltung bezeichnet. Die erste Klemmschaltung befindet sich also parallel zum Schalter des ersten Ausgangszweigs und die zweite Klemmschaltung parallel zum Schalter des zweiten Ausgangszweigs.

Als Klemmschaltung wird hier und im Folgenden eine zur sogenannten aktiven Klemmung (active clamping) bestimmte und wirksame Schaltung bezeichnet. Dies folgt dem Sprachgebrauch in der üblichen Fachterminologie, wo eine solche Schaltung als active clamper oder kurz als clamper und deren Funktion als active clamping bezeichnet wird. Eine Klemmschaltung ist ein elektrisches Netzwerk - beim im Folgenden beschriebenen Ausführungsbeispiel ein elektrischer Zweipol -, welches zumindest eine Diode und als Energiespeicher einen Kondensator umfasst, wobei die Diode in Richtung an den Kondensator in Durchlassrichtung geschaltet ist, und welches ein angelegtes Signal ohne Änderung der Signalform auf einen anderen Pegel - regelmäßig einen erhöhten Pegel - verschiebt. Bei einer aktiven Klemmschaltung ist diese Funktion aktivierbar. Dafür umfasst die aktive Klemmschaltung einen Schalter. Bei offenem Schalter kann Strom über die Diode in den Kondensator der Klemmschaltung fließen und es erfolgt ein Speichern/Zwischenspeichern elektrischer Energie im Kondensator. Bei geschlossenem Schalter wird die zuvor im Kondensator gespeicherte Energie in die umgebende Schaltung - hier die Verstärkerschaltung - abgegeben und zwar auf dem durch die Bauteile der Klemmschaltung bestimmten veränderten, insbesondere erhöhten Pegel.

Die beiden aktiven Klemmschaltungen umfassen insbesondere zumindest die folgenden Bauteile: Einen Schalter, einen Kondensator und eine Diode. Die beiden aktiven Klemmschaltungen umfassen den Schalter, den Kondensator und/oder die Diode nicht notwendig als diskrete Bauteile. Vorteilhaft kommt zum Beispiel in Betracht, dass als Schalter der aktiven Klemmschaltungen jeweils ein MOSFET fungiert und dieser die Diode als Bodydiode umfasst.

Die beiden aktiven Klemmschaltungen schützen jeweils den Schalter, zu dem sie parallelgeschaltet sind. Eine aufgrund der Streuinduktivität resultierende Spannungsspitze kann so nicht mehr entstehen und gefährdet diese Schalter nun nicht mehr. Die Schalter sind durch die beiden aktiven Klemmschaltungen geschützt - geschützte Schalter. Die elektrische Energie einer Spannungsspitze wird bei offenem geschütztem Schalter in den Kondensator der Klemmschaltung geleitet. Aufgrund der Schutzwirkung der beiden Klemmschaltungen ist eine Überdimensionierung der geschützten Schalter nicht mehr erforderlich. Aufgrund der Ableitung der Energie der aufgrund der Streuinduktivität resultierenden Spannungsspitzen in die Kondensatoren der beiden aktiven Klemmschaltungen geht diese Energie jetzt nicht mehr verloren und kann in die umgebende Verstärkerschaltung, also den ausgangsseitigen Teil der Verstärkerschaltung, zurückgespeist werden. Dafür wird zeitweise (getaktet) der ansonsten offene Schalter der jeweiligen aktiven Klemmschaltung geschlossen.

Vorteilhafte Ausgestaltungen der hier vorgeschlagenen Neuerung sind Gegenstand der Unteransprüche. Dabei verwendete Rückbeziehungen innerhalb der Ansprüche weisen auf die weitere Ausbildung des Gegenstandes des in Bezug genommenen Anspruchs durch die Merkmale des jeweiligen abhängigen Anspruchs hin. Sie sind nicht als ein Verzicht auf die Erzielung eines selbständigen, gegenständlichen Schutzes für die Merkmale oder Merkmalskombinationen eines abhängigen Anspruchs zu verstehen. Des Weiteren ist im Hinblick auf eine Auslegung der Ansprüche sowie der Beschreibung bei einer näheren Konkretisierung eines Merkmals in einem abhängigen Anspruch davon auszugehen, dass eine derartige Beschränkung in den jeweils vorangehenden Ansprüchen sowie einer allgemeineren Ausführungsform der gegenständlichen Verstärkerschaltung / des Verfahrens zu deren Betrieb nicht vorhanden ist. Jede Bezugnahme in der Beschreibung auf Aspekte abhängiger Ansprüche ist demnach auch ohne speziellen Hinweis ausdrücklich als Beschreibung optionaler Merkmale zu lesen. Schließlich ist darauf hinzuweisen, dass das hier angegebene Verfahren auch entsprechend der abhängigen Vorrichtungsansprüche weitergebildet sein kann und umgekehrt.

Bei einer Ausführungsform der Verstärkerschaltung ist der Schalter jeder aktiven Klemmschaltung grundsätzlich offen und bei offenem Schalter ist elektrische Energie aus der umgebenden Verstärkerschaltung in den Kondensator der aktiven Klemmschaltung ladbar und wird beim Betrieb der Verstärkerschaltung bei offenem Schalter in den Kondensator der aktiven Klemmschaltung geladen. Jeder dieser grundsätzlich offenen Schalter ist getaktet schließbar und wird beim Betrieb der Verstärkerschaltung getaktet geschlossen, wobei bei geschlossenem Schalter in dem Kondensator gespeicherte elektrische Energie in die umgebende Verstärkerschaltung zurückspeisbar ist (und zwar durch Einspeisung in den Übertrager) und beim Betrieb der Verstärkerschaltung in die umgebende Verstärkerschaltung zurückgespeist wird. Die die aktive Klemmschaltung umgebende Verstärkerschaltung ist dabei jeweils deren Ausgangsseite. Auf der Ausgangsseite der Verstärkerschaltung wird also bei einer aktiven Klemmschaltung mit offenem Schalter elektrische Energie in deren Kondensator geladen und bei einer aktiven Klemmschaltung mit geschlossenem Schalter aus deren Kondensator in die Verstärkerschaltung zurückgespeist.

Für die weitere Beschreibung gilt zur Vermeidung unnötiger Wiederholungen, dass Merkmale und Details, die im Zusammenhang mit dem Betrieb der Verstärkerschaltung, also einem Verfahren zum Betrieb der Verstärkerschaltung, sowie eventueller Ausgestaltungen beschrieben sind, selbstverständlich auch im Zusammenhang mit und für eine zur Durchführung des Verfahrens bestimmte und eingerichtete Verstärkerschaltung und umgekehrt gelten. Folglich kann das Verfahren auch mittels einzelner oder mehrerer Verfahrensmerkmale fortgebildet sein, die sich auf von der Verstärkerschaltung ausgeführte oder mittels der Verstärkerschaltung ausführbare Verfahrensschritte beziehen, und die Verstärkerschaltung kann entsprechend auch durch Mittel zur Ausführung von im Rahmen des Verfahrens ausgeführten Verfahrensschritten fortgebildet sein. Dementsprechend gelten Merkmale und Details, die im Zusammenhang mit dem Betrieb der Verstärkerschaltung und eventueller Ausgestaltungen eines solchen Betriebsverfahrens beschrieben sind, selbstverständlich auch im Zusammenhang mit und für die Verstärkerschaltung und jeweils umgekehrt, so dass bezüglich der Offenbarung zu den einzelnen Aspekten der Erfindung stets wechselseitig Bezug genommen wird bzw. werden kann.

Bei einem Verfahren zum Betrieb einer Verstärkerschaltung der hier und im Folgenden beschriebenen Art ist bevorzugt vorgesehen, dass der Schalter der ersten aktiven Klemmschaltung während einer Phase, während der der Schalter des zweiten Ausgangszweigs geschlossen ist, geöffnet wird und dass der Schalter der zweiten aktiven Klemmschaltung während einer Phase, während der der Schalter des ersten Ausgangszweigs geschlossen ist, geöffnet wird. Entsprechend ist der Schalter der ersten aktiven Klemmschaltung während einer Phase, während der der Schalter des zweiten Ausgangszweigs offen ist, geschlossen und der Schalter der zweiten aktiven Klemmschaltung ist während einer Phase, während der der Schalter des ersten Ausgangszweigs offen ist, geschlossen. Ein Schutz der Schalter der beiden Ausgangszweige ist vor allem dann notwendig, wenn diese offen sind. Zumindest dann, wenn diese offen sind, sind auch die Schalter der jeweils parallel geschalteten aktiven Klemmschaltungen offen. Eine Spannungsspitze - genauer: die Energie, welche in der Streuinduktivität gespeichert war - wird dann nicht über den Ausgangszweig und den dortigen offenen Schalter abgeleitet. Vielmehr wird die elektrische Energie über die in Richtung auf den Kondensator der aktiven Klemmschaltung in Durchlassrichtung geschaltete Diode in den Kondensator der jeweiligen aktiven Klemmschaltung geladen. Weil sich der Schaltzustand der Schalter in den Ausgangszweigen zum Erhalt der Verstärkungswirkung der Verstärkerschaltung zyklisch ändert, ändert sich entsprechend auch die Schaltstellung der von den aktiven Klemmschaltungen umfassten Schalter.

Bevorzugt ist dabei vorgesehen, dass auf der Eingangsseite der Verstärkerschaltung in grundsätzlich an sich bekannter Art und Weise in Abhängigkeit von einer Schaltstellung der dortigen Schalter einerseits ein Stromfluss in Richtung auf den Übertrager in einer ersten Stromflussrichtung und andererseits einer entgegengesetzten zweiten Stromflussrichtung erzeugt wird. Bei einer ersten Stromflussrichtung auf der Eingangsseite ist/wird in einem der Ausgangszweige der dortige Schalter geschlossen und bei der entgegengesetzten zweiten eingangsseitigen Stromflussrichtung ist/wird in dem anderen Ausgangszweig der dortige Schalter geschlossen. Für die weitere Beschreibung wird dies so formuliert, dass bei einem in die erste Stromflussrichtung erzeugten eingangsseitigen Stromfluss auf der Ausgangsseite der Schalter des zweiten Ausgangszweigs und bei einem in die zweite Stromflussrichtung erzeugten eingangsseitigen Stromfluss auf der Ausgangsseite der Schalter des ersten Ausgangszweigs geschlossen wird. Zur weiteren Definition einer Ausführungsform des Verfahrens kann dann formuliert werden, dass bei einem in die erste Stromflussrichtung erzeugten eingangsseitigen Stromfluss auf der Ausgangsseite der Schalter der ersten aktiven Klemmschaltung geschlossen wird und dass bei einem in die zweite Stromflussrichtung erzeugten eingangsseitigen Stromfluss auf der Ausgangsseite der Schalter der zweiten aktiven Klemmschaltung geschlossen wird.

Bei einer nochmals weiteren Ausführungsform des Verfahrens ist das Schließen der Schalter der ersten und zweiten aktiven Klemmschaltung mit einer eine jeweilige eingangsseitige Stromrichtung hervorrufenden Änderung der Schaltstellung der eingangsseitigen Schalter korreliert. Dieses korrelierte Schließen der Schalter der beiden aktiven Klemmschaltungen erfolgt mit einem Zeitversatz nach der Änderung der Schaltstellung der eingangsseitigen Schalter und endet mit einem weiteren Zeitversatz vor einer nächstfolgenden Schaltstellung der eingangsseitigen Schalter.

Das hier und im Folgenden beschriebene Verfahren zum Betrieb der gegenständlichen Verstärkerschaltung ist zur automatischen Ausführung zum Beispiel in Form eines Computerprogramms realisiert und ein Ansteuerungsschema der von der Verstärkerschaltung einschließlich der aktiven Klemmschaltungen der Verstärkerschaltung umfassten Schalter ist eine Implementierung des Verfahrens zum Betrieb der gegenständlichen Verstärkerschaltung. Die hier vorgeschlagene Neuerung ist damit einerseits auch zum Beispiel ein Computerprogramm mit durch eine elektronische Steuerungseinrichtung ausführbaren Programmcodeanweisungen und andererseits ein Speichermedium mit einem derartigen Computerprogramm, also ein Computerprogrammprodukt mit Programmcodemitteln, sowie schließlich auch eine Steuerungseinrichtung, in deren Speicher als Mittel zur Durchführung des Verfahrens und seiner Ausgestaltungen ein solches Computerprogramm geladen oder ladbar ist.

Das Computerprogramm umfasst Programmcodemittel, um alle Schritte des hier vorgeschlagenen Verfahrens oder spezieller Ausführungsformen des Verfahrens durchzuführen, wenn dieses mittels einer von einer hier und im Folgenden beschriebenen Verstärkerschaltung umfassten Steuerungseinrichtung ausgeführt wird. Eine Verstärkerschaltung mit einer solchen Steuerungseinrichtung stellt eine spezielle, bevorzugte Ausführungsform der hier vorgeschlagenen Verstärkerschaltung dar und umfasst eine solche, zur Generierung von Ansteuersignalen für die von der Verstärkerschaltung einschließlich der aktiven Klemmschaltungen der Verstärkerschaltung umfassten Schalter bestimmte Steuerungseinrichtung, nämlich eine Steuerungseinrichtung, welche beim Betrieb der Verstärkerschaltung ein Verfahren zum Betrieb der Verstärkerschaltung gemäß der hier vorgelegten Beschreibung ausführt.

Anstelle eines Computerprogramms mit einzelnen Programmcodeanweisungen kann die Implementierung des hier und im Folgenden beschriebenen Verfahrens auch in Form von Firmware erfolgen. Dem Fachmann ist klar, dass anstelle einer Implementation eines Verfahrens in Software stets auch eine Implementation in Firmware oder in Firm- und Software oder in Firm- und Hardware möglich ist. Daher soll für die hier vorgelegte Beschreibung gelten, dass von den Begriffen Software oder Computerprogramm auch andere Implementationsmöglichkeiten, insbesondere eine Implementation in Firmware oder in Firm- und Software oder in Firm- und Hardware, umfasst sind. Ein Bespiel dafür ist ein Computerprogrammprodukt mit elektronisch auslesbaren Steuersignalen, insbesondere ein ASIC, FPGA oder dergleichen, welche eine Ausführung eines Verfahrens der hier und im Folgenden beschriebenen Art bewirken.

Wenn im Folgenden Verfahrensschritte oder Verfahrensschrittfolgen beschrieben werden, bezieht sich dies auf Aktionen, die aufgrund eines Computerprogramms mit einer Implementation des Verfahrens oder unter Kontrolle eines solchen Computerprogramms oder unter Kontrolle einer Steuerungseinrichtung mit einer Implementation des Verfahrens erfolgen.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das oder jedes Ausführungsbeispiel ist nicht als Einschränkung der Erfindung zu verstehen. Vielmehr sind im Rahmen der vorliegenden Offenbarung durchaus auch Ergänzungen und Modifikationen möglich, insbesondere solche, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten oder Verfahrensschrittfolgen führen.

Es zeigen
- FIG 1: eine Verstärkerschaltung,
- FIG 2: eine Verstärkerschaltung mit passive clamping,
- FIG 3 - FIG 6: eine Verstärkerschaltung mit ausgangsseitigem active clamping mit Momentaufnahmen unterschiedlicher Schaltstellungen während des Betriebs der Verstärkerschaltung,
- FIG 7 - FIG 8: und unterschiedliche Anschlussmöglichkeiten einer Last an eine Verstärkerschaltung gemäß FIG 3 bis FIG 6 sowie
- FIG 9 - FIG 11: weitere Schaltungsvarianten einer Verstärkerschaltung mit dem hier vorgeschlagenen ausgangsseitigen active clamping.

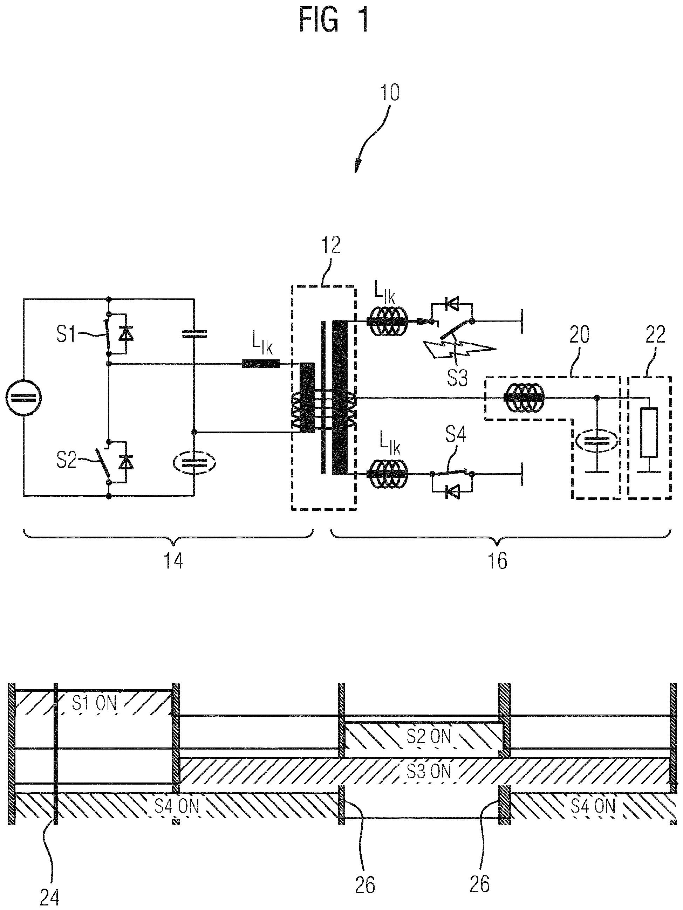

FIG 1 zeigt eine Verstärkerschaltung 10 sowie unterhalb der Verstärkerschaltung 10 in einem Zeitdiagramm den Schaltzustand der von der Verstärkerschaltung 10 umfassten Schalter S1, S2, S3, S4 (ein der symbolischen Bezeichnung der Schalter S1-S4 nachgestelltes "ON" - also "S1 ON" usw. - bedeutet einen geschlossenen Schalter S1-S4). Die Verstärkerschaltung 10 umfasst einen Übertrager 12 mit einer eingangsseitigen Induktivität und einer ausgangsseitigen Induktivität. Die beiden Induktivitäten des Übertragers 12 sind in an sich bekannter Art und Weise elektromagnetisch gekoppelt. Vom Übertrager 12 aus gesehen umfasst die Verstärkerschaltung 10 eine Eingangsseite 14 und eine Ausgangsseite 16 und die Eingangsseite 14 und die Ausgangsseite 16 der Verstärkerschaltung 10 sind mittels des Übertragers 12 (galvanisch getrennt) gekoppelt.

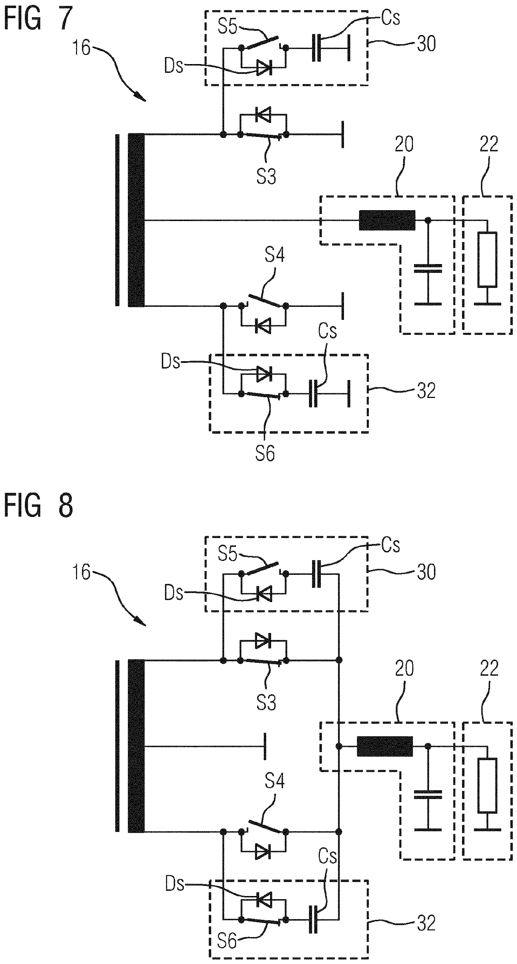

Auf der Ausgangsseite 16 ist im Anschluss an eine als Filter 20 fungierende LC-Kombination eine Last 22 angeschlossen. FIG 1, FIG 2 und FIG 3 bis FIG 6 sowie FIG 7 zeigen eine Anschlussmöglichkeit der Last 22. FIG 8 zeigt eine alternative Anschlussmöglichkeit der Last 22.

Die grundsätzliche Funktion der Verstärkerschaltung 10 ist bereits in der WO 2018/086899 A1 beschrieben. Auf diese wird hier neben der kurzen Funktionsbeschreibung weiter oben verwiesen. Mit diesem Verweis soll die WO 2018/086899 A1 mit ihrem vollständigen Offenbarungsgehalt bezüglich der Funktion der Verstärkerschaltung 10 in die hier vorgelegte Beschreibung einbezogen gelten. Die Eingangsseite 14 der Verstärkerschaltung 10 entspricht dem in der WO 2018/086899 A1 mit der Bezugsziffer 11 bezeichneten Schaltungsteil (in der WO 2018/086899 A1 als erste Schaltstufe bezeichnet) der dortigen Verstärkerschaltung. Die Ausgangsseite 16 der Verstärkerschaltung 10 entspricht dem in der WO 2018/086899 A1 mit der Bezugsziffer 13 bezeichneten Schaltungsteil ("zweite Schaltstufe" in der WO 2018/086899 A1).

Kritisch ist bei einer auf elektronmagnetischer Energieübertragung basierenden Verstärkerschaltung 10 die Streuinduktivität (leakage inductance) des Übertragers 12. Die Darstellung in FIG 1 umfasst insoweit eine symbolische Darstellung der Streuinduktivität in Form zusätzlicher Induktivitäten Lₗₖ (der Index lk steht für "leakage"). Bei einem Stromfluss auf der Eingangsseite 14 - zum Beispiel über den Schalter S1 - führt die Magnetisierung der Eingangsseite des Übertragers 12 zu einer Magnetisierung der Ausgangsseite des Übertragers 12 und damit zu einem Stromfluss auf der Ausgangsseite 16 in dem Zweig mit der Last 22 und dem zu diesem Zeitpunkt geschlossenen Schalter S4. Bei einem Stromfluss auf der Eingangsseite 14 über den Schalter S2 ist die Schaltstellung auf der Ausgangsseite 16 angepasst (S3 geschlossen, S4 offen) und die resultierende Magnetisierung des Übertragers 12 auf dessen Ein- und Ausgangsseite führt auf der Ausgangsseite 16 zu einem Stromfluss in dem Zweig mit der Last 22 und dem dann geschlossenen Schalter S3.

Zur vereinfachten Benennung werden die jeweils einen Schalter S3, S4 aufweisenden Zweige auf der Ausgangsseite 16 als erster ausgangsseitiger Zweig und als zweiter ausgangsseitiger Zweig bezeichnet. Der erste ausgangsseitige Zweig umfasst den Schalter S3. Der zweite ausgangsseitige Zweig umfasst den Schalter S4. Der Zweig mit der Last 22 ist der Lastzweig. Bei eingangsseitig geschlossenem Schalter S1 (der Schalter S2 ist dann offen) ist nur der zweite ausgangsseitige Zweig aktiv und der dortige Schalter S4 geschlossen. Bei eingangsseitig geschlossenem Schalter S2 (der Schalter S1 ist dann offen) ist nur der erste ausgangsseitige Zweig aktiv und der dortige Schalter S3 geschlossen.

In dem Zeitdiagramm stellt eine vertikale Linie den jeweils momentanen Zeitpunkt 24 dar und anhand des Zeitpunkts 24 sind in dem Zeitdiagramm die zu dem jeweiligen Zeitpunkt 24 wirksamen Schaltzustände der Schalter S1, S2, S3, S4 ablesbar. Schraffierte Bereiche 26 entlang der Zeitachse (zum Teil nur einzelne bezeichnet) stellen eine Ummagnetisierung (genauer: die Totzeit in welcher die Spannung über den Wicklungen des Übertragers 12 umschwingt; zum Beginn des jeweiligen Bereichs 25 startet die Ummagnetisierung des Übertragers 12) des Übertragers 12 und/oder der vom Übertrager 12 umfassten Streuinduktivitäten Lₗₖ und deren ungefähre zeitliche Dauer dar.

Bei den zur Vereinfachung als mechanische Schalter gezeigten Schaltern S1, S2, S3, S4 handelt es sich in der Praxis um elektronische Schaltelemente, also zum Beispiel um MOSFETs oder dergleichen. Dies gilt in Bezug auf alle von der hier vorgelegten Beschreibung umfasste Figuren und auch in Bezug auf eventuelle weitere dortige Schalter. Des weiteren bedeuten Begriffe wie "öffnen", "schließen", "geöffnet", "geschlossen" und dergleichen eine entsprechende Ansteuerung des Schaltelements, so dass ein Öffnen, ein Schließen, ein geöffneter (Schalt-)Zustand bzw. ein geschlossener (Schalt-)usw. resultiert.

In der Darstellung in FIG 1 (und im Wesentlichen auch in allen weiteren Figuren) ist in einem Bauteil der Verstärkerschaltung 10 gespeicherte elektrische Energie durch eine Umrandung (bei in einer Induktivität gespeicherter Energie in Form mehrerer Kreise um die Induktivität; bei in einer Kapazität gespeicherter Energie in Form einer gestrichelten Umrandung) gezeigt. Diese Kennzeichnung fehlt bei solchen induktiven oder kapazitiven Bauteilen, in denen zum jeweils darstellten Zeitpunkt keine elektrische Energie gespeichert ist.

Bei einer Unterbrechung des Stromflusses in einem der Ausgangszweige durch Öffnen des jeweiligen dortigen Schalters S3, S4 oder bei einer Änderung der Richtung des Stromflusses in einem dieser Ausgangszweige aufgrund einer Änderung der Schaltstellung der eingangsseitigen Schalter S1, S2 führt die Stromänderung (Unterbrechung oder Richtungsänderung) zu einer Spannungsspitze aufgrund der in diesem Ausgangszweig wirksamen Streuinduktivität Lₗₖ. Dies wiederum führt zu einer Gefährdung derjenigen (ausgangsseitigen) Komponenten der Verstärkerschaltung 10, auf welche die Spannungsspitze wirkt.

Zur Vermeidung einer solchen Gefährdung und eventuell resultierender Beschädigungen der gefährdeten Komponenten der Verstärkerschaltung 10 kommt eine entsprechende Dimensionierung der gefährdeten Komponenten in Betracht. Eine solche Dimensionierung stellt im Grunde eine Überdimensionierung dar. Zumindest führt eine solche Dimensionierung zu erhöhten Kosten und regelmäßig auch zu zusätzlich benötigtem Bauraum.

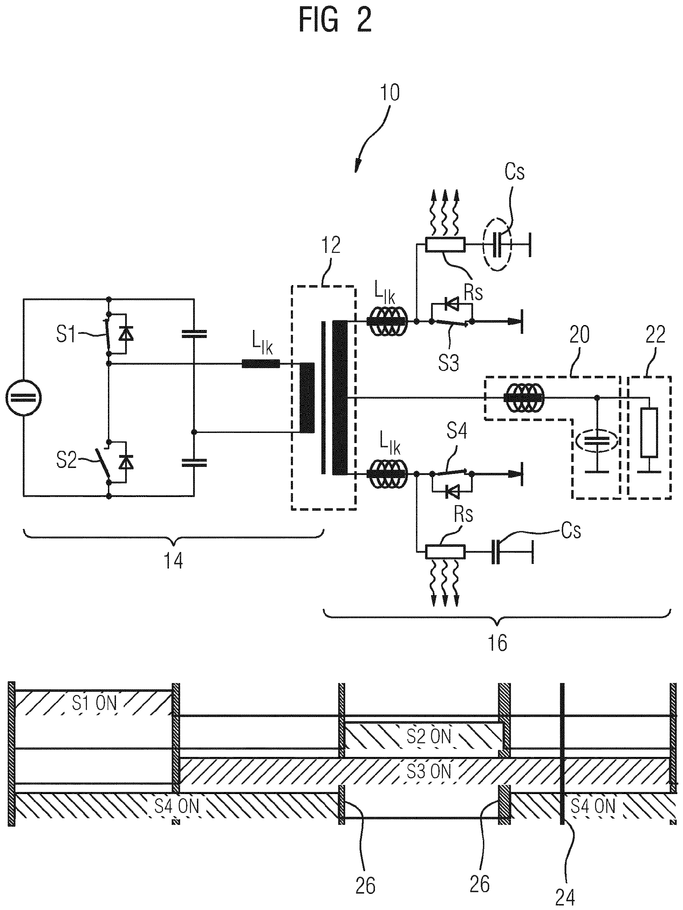

Als Alternative zu einer solchen Überdimensionierung ist das sogenannte passive clamping bekannt. In der Darstellung in FIG 2 ist die Verstärkerschaltung 10 gemäß FIG 1 mit passive clamping auf der Ausgangsseite 16 gezeigt.

Beim passive clamping wird allerdings die in der Streuinduktivität Lₗₖ gespeicherte Energie über einen ohmschen Widerstand (in der Darstellung in FIG 2 mit R_{S} bezeichnet) abgeleitet und damit in Form von Wärmeenergie verbraucht. Die entstehende Wärmeenergie ist schematisch vereinfacht mittels von dem Widerstand Rₛ ausgehender Pfeile gezeigt. Die so verbrauchte Energie steht für die Speisung der Last 22 nicht mehr zur Verfügung (Energieverlust). Konkret wird beim passive clamping die in der Streuinduktivität Lₗₖ gespeicherte Energie temporär und teilweise in einem in Reihe mit dem ohmschen Widerstand geschalteten Kondensator (in der Darstellung in FIG 2 mit C_{S} bezeichnet) gespeichert. Die Reihenschaltung aus dem Widerstand Rₛ und dem Kondensator C_{S} bildet eine RC-Kombination. Beim Aufladen des Kondensators Cₛ sowie beim Entladen des Kondensators Cₛ wird die zuvor in der Streuinduktivität Lₗₖ gespeicherte Energie an dem Widerstand R_{S} der RC-Kombination verbraucht. Der resultierende Energieverlust fällt dabei besonders ins Gewicht, weil er sich in jedem Übertragerzyklus ergibt.

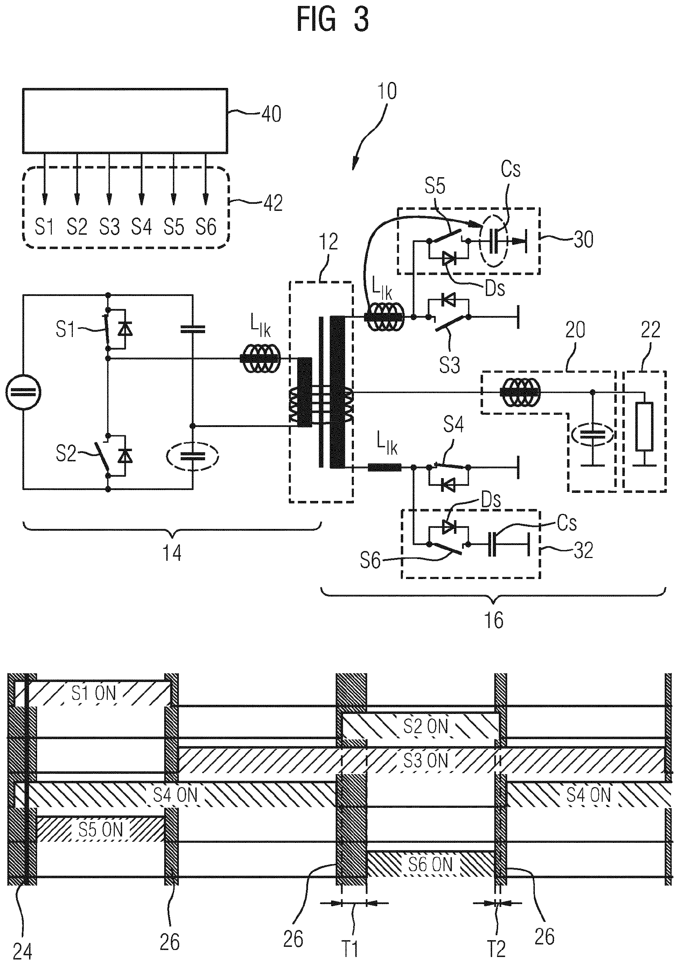

Die hier vorgeschlagene Neuerung vermeidet Überdimensionierungen und einen Energieverlust. Dafür tritt an die Stelle des grundsätzlich möglichen passive clamping eine im Folgenden als active clamping bezeichnete Beschaltung. Die Darstellung in FIG 3 zeigt eine Ausführungsform einer Verstärkerschaltung 10 gemäß FIG 1 mit active clamping.

Beim active clamping tritt an die Stelle der RC-Kombination des passive clamping (FIG 2) eine Kombination aus einem Schalter S5, S6, einer Diode Dₛ und einem Kondensator Cₛ. Diese Kombination - Schalter S5, S6, Diode Dₛ und Kondensator Cₛ - wird entsprechend der vorgesehenen Funktion (active clamping) als aktive Klemmschaltung 30, 32 (active clamp) bezeichnet. Die Verstärkerschaltung 10 umfasst auf der Ausgangsseite 16 in jedem der beidseitig vom Übertrager 12 ausgehenden Zweige (erster Ausgangszweig, zweiter Ausgangszweig) und parallel zu dem dortigen jeweiligen Schalter S3, S4 eine aktive Klemmschaltung 30, 32 (erste aktive Klemmschaltung 30, zweite aktive Klemmschaltung 32) mit jeweils einem Schalter S5, S6, einer Diode Dₛ und einem Kondensator Cₛ. Der Schalter S5, S6 der aktiven Klemmschaltung 30, 32 umfasst bei einer Ausführung als MOSFET oder dergleichen als Diode Dₛ eine Bodydiode oder dem Schalter S5, S6 ist eine Diode D_{S} mit entsprechender Sperrrichtung separat zugeordnet.

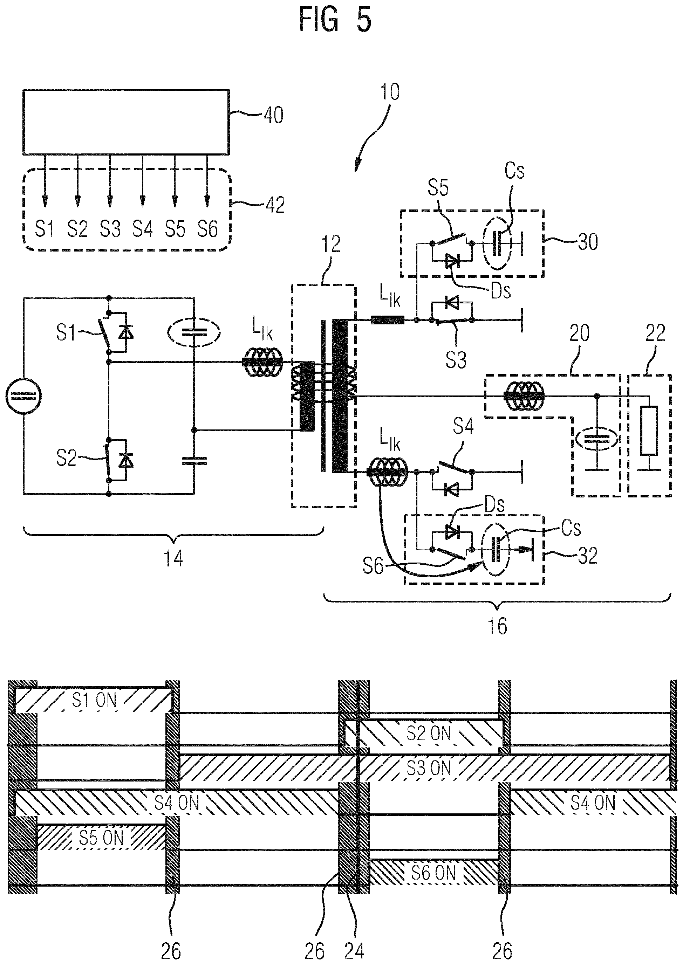

Die Bodydiode D_{S} oder die separate Diode D_{S} - im Folgenden zusammenfassend als Diode D_{S} bezeichnet - leitet in Richtung auf den Kondensator Cₛ der aktiven Klemmschaltung 30, 32. Damit wird (bei geöffnetem Schalter S5, S6 der aktiven Klemmschaltung 30, 32) in der Streuinduktivität Lₗₖ gespeicherte Energie über die Diode D_{S} der aktiven Klemmschaltung 30, 32 in den nachfolgenden Kondensator Cₛ der aktiven Klemmschaltung 30, 32 geladen. Dies ist in der Darstellung in FIG 3 (und FIG 5) gezeigt.

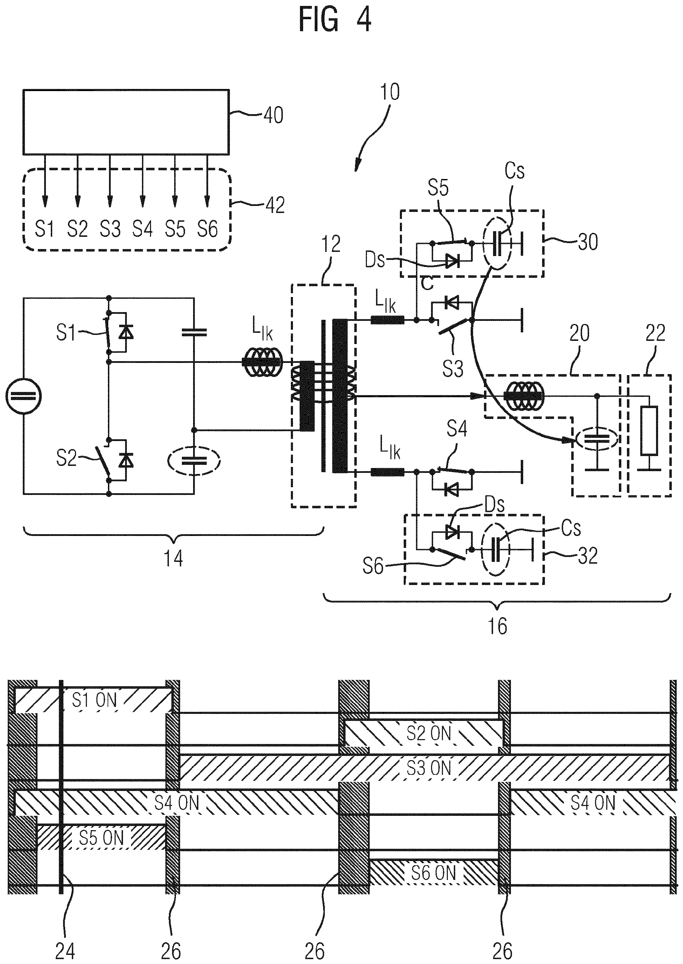

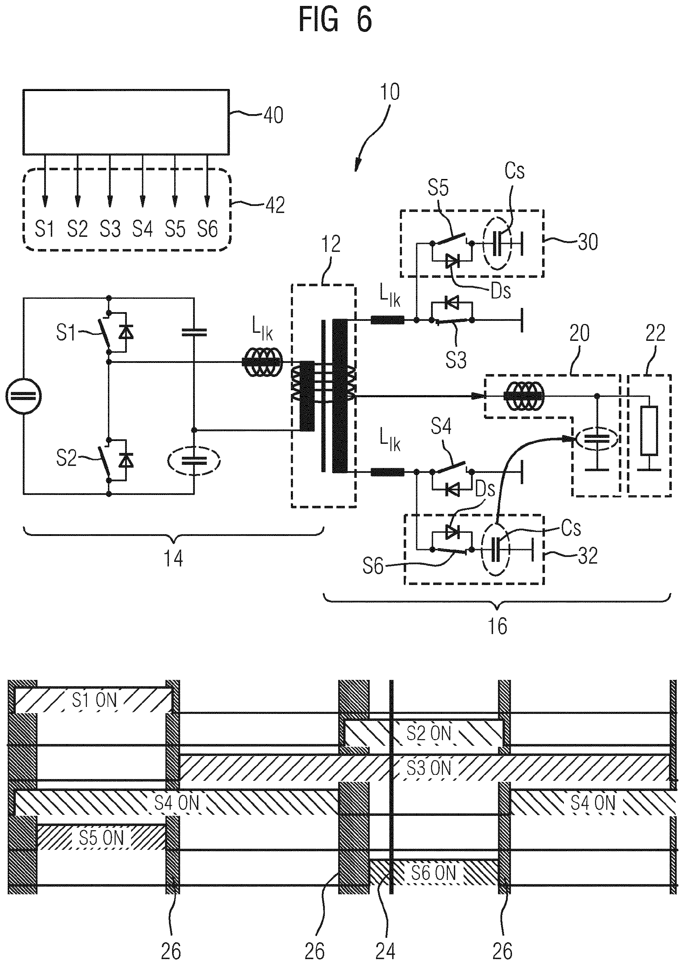

Wenn der Schalter S5, S6 der aktiven Klemmschaltung 30, 32 geschlossen wird, wird der zuvor geladene Kondensator Cₛ über den geschlossenen Schalter S5, S6 entladen. Dies zeigt die Darstellung in FIG 4 (und FIG 6). Beim Entladen wird die zuvor in Streuinduktivität Lₗₖ gespeicherte - und mittels der aktiven Klemmschaltung 30, 32 in deren Kondensator Cₛ gewissermaßen zwischengespeicherte - elektrische Energie wieder in Richtung auf den Übertrager 12 abgegeben und steht damit letztlich zur Versorgung der Last 22 voll zur Verfügung.

Die Darstellungen in FIG 3 und FIG 4 zeigen das Zwischenspeichern der elektrischen Energie im Kondensator Cₛ der ersten aktiven Klemmschaltung 30 bzw. die Rückspeisung der dort gespeicherten elektrischen Energie in den Zweig mit der Last 22. Die Darstellungen in FIG 5 und FIG 6 zeigen entsprechend das Zwischenspeichern der elektrischen Energie im Kondensator Cₛ der zweiten aktiven Klemmschaltung 32 bzw. die Rückspeisung der dort gespeicherten elektrischen Energie in den Zweig mit der Last 22.

Abhängig von der Kapazität des Kondensators Cₛ jeder aktiven Klemmschaltung 30, 32 liegt die mittels der aktiven Klemmschaltung 30, 32 erzeugte (die mittels der aktiven Klemmschaltung 30, 32 in Richtung auf den Übertrager 12 zurückgespeiste) Spannung gerade über der Ausgangsspannung des Übertragers 12 und erhöht damit die für die Last 22 verfügbare Ausgangsspannung der Verstärkerschaltung 10 - wenn der Kondensator Cₛ genügen groß ist (die Ladung erhöht so die Spannung am Kondensator Cₛ nur minimal) wird die Spannung um die Diodenspannung erhöht. Umgekehrt wird der mit dem passive clamping einhergehende Energieverlust nach dem hier vorgeschlagenen Ansatz - active clamping - vermieden. Auch eine Überdimensionierung der Bauteile ist nicht erforderlich, weil beim Laden des Kondensators Cₛ der aktiven Klemmschaltung 30, 32 deren Diode in Durchlassrichtung durchströmt wird.

In der Darstellung in FIG 3 (und in den weiteren Darstellung in FIG 4 bis FIG 6) ist neben der bereits weiter oben im Zusammenhang mit der Erläuterung der Darstellung in FIG 1 erwähnten Darstellung der Stromflusspfade durch Pfeile von einem Bauteil zu einem anderen Bauteil der Verstärkerschaltung 10 ein Energietransfer zwischen diesen Bauteilen gezeigt Bei der Darstellung in FIG 3 ist die der Energietransfer von der Streuinduktivität Lₗₖ in den Kondensator Cₛ der ersten aktiven Klemmschaltung 30.

Die Darstellungen in FIG 7 und FIG 8 zeigen jeweils nur die Ausgangsseite 16 einer Verstärkerschaltung 10 gemäß FIG 1 und dort unterschiedliche Anschlussmöglichkeiten der Last 22. Die Anschlusssituation in FIG 7 entspricht der Anschlusssituation in den vorangehenden Figuren. Die Anschlusssituation in FIG 8 ist eine alternative Anschlusssituation.

Die Darstellungen in FIG 7 und FIG 8 zeigen die beiden ausgangsseitigen aktiven Klemmschaltungen 30, 32, welche nach dem hier vorgeschlagenen Ansatz zum active clamping bestimmt sind und beim Betrieb der Verstärkerschaltung 10 ein active clamping bewirken. In den Darstellungen in FIG 7 und FIG 8 ist - lediglich exemplarisch - eine momentane Schaltstellung der von den aktiven Klemmschaltungen 30, 32 umfassten Schalter S5, S6 sowie ebenfalls eine momentane Schaltstellung der weiteren ausgangsseitigen Schalter S3, S4 gezeigt.

Der Schalter S5 der ersten aktiven Klemmschaltung 30 und der Schalter S6 der zweiten aktiven Klemmschaltung 32 ist normalerweise offen. Bei offenen Schaltern S5, S6 ist das ausgangsseitige Zwischenspeichern elektrischer Energie in den Kondensatoren Cₛ der aktiven Klemmschaltungen 30, 32 möglich. Das Schließen jedes dieser Schalter S5, S6 erfolgt korreliert mit den Phasen der Magnetisierung der Eingangsseite des Übertragers 12 und dem zugrunde liegenden Schließen der eingangsseitigen Schalter S1, S2 und einmal in jedem Übertragerzyklus (ein Übertragerzyklus dauert vom erstmaligen Schließen eines eingangsseitigen Schalters S1, S2 - zum Beispiel des Schalters S1 - bis unmittelbar vor das nächste Schließen desselben Schalters). Das Schließen und die Dauer des geschlossenen Zustands der Schalter S5, S6 ist in den Zeitdiagrammen im unteren Bereich der Darstellungen in FIG 3 bis FIG 6 durch die jeweiligen "ON-Phasen", also "S5 ON" und "S6 ON", gezeigt.

Das Schließen der Schalter S5, S6 der aktiven Klemmschaltungen 30, 32 erfolgt jedoch mit einem gewissen Zeitversatz nach dem Schließen eines der eingangsseitigen Schalter S1, S2, wie dies anhand der Zeitdiagramme in den Darstellungen in FIG 3 bis FIG 6 erkennbar ist. Eine Dauer T₁ (nur in FIG 3 eingezeichnet) des Zeitversatzes - anfänglicher Zeitversatz - ergibt sich anhand der Dauer des aufgrund einer Stromänderung resultierenden und von der Streuinduktivität Lₗₖ hervorgerufenen Spannungsspitze. Die Dauer T₁ des anfänglichen Zeitversatzes kann anhand der erwarteten Dauer der Spannungsspitze geschätzt werden. Die Dauer T₁ entspricht zum Beispiel der mit einem Faktor k (k > 1) multiplizierten Dauer T_{S}: T₁ = k Tₛ. Der Kondensator Cₛ muss so gewählt werden, dass die Energie während des kleinsten Duty Cycles, also des Tastgrades, sowohl gespeichert als auch wieder abgegeben werden kann.

Auch das anschließende Öffnen jedes dieser Schalter S5, S6 erfolgt korreliert mit den Phasen der Magnetisierung der Eingangsseite des Übertragers 12 und dem zugrunde liegenden Öffnen der eingangsseitigen Schalter S1, S2. Auch das Öffnen erfolgt nicht zeitgleich mit dem Öffnen des jeweiligen eingangsseitigen Schalters S1, S2, sondern mit einem weiteren Zeitversatz - finaler Zeitversatz - vor dem Öffnen des eingangsseitigen Schalters S1, S2. Eine Dauer T₂ (ebenfalls nur in FIG 3 eingezeichnet) dieses weiteren, finalen Zeitversatzes muss so gewählt sein, dass das freie Umschwingen der Spannung am Übertrager 12 gewährleistet ist (würde der Schalter S5,S6 zu spät ausgeschaltet, würde die Kondensatorspannung durch das Umschwingen der Übertragerspannung entladen).

Die korrelierte Ansteuerung sämtlicher Schalter S1-S6 erfolgt mittels einer der Verstärkerschaltung 10 zugeordneten, insbesondere einer von der Verstärkerschaltung 10 umfassten Steuerungseinrichtung 40. Diese erzeugt - wie dies schematisch vereinfacht in FIG 3 bis FIG 6 gezeigt ist - Ansteuersignale 42 zur Ansteuerung der Schalter S1-S6. Das jeweilige Ansteuersignal 42 bestimmt die Schaltstellung des betreffenden Schalters S1-S6. Die Steuerungseinrichtung 40 umfasst dafür - in Soft-, Hard- und/oder Firmware implementiert - ein Steuerungsprogramm bzw. eine Steuerungslogik.

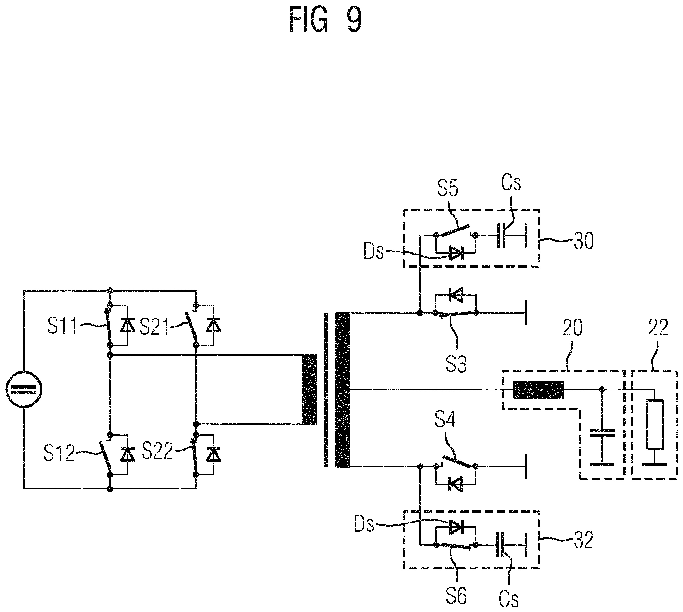

Die Steuerungseinrichtung 40 bestimmt die Schaltstellung der Schalter S1-S4 zum Erhalt der gewünschten Verstärkung der auf der Eingangsseite 14 eingespeisten Spannung auf der Ausgangsseite 16. Wenn die Verstärkerschaltung 10 bei einer entsprechenden Implementation mehr als diese vier Schalter S1-S4 zum Zwecke der Verstärkung der auf der Eingangsseite 14 eingespeisten Spannung aufweist (siehe zum Beispiel FIG 9), erzeugt die Steuerungseinrichtung 40 auch Ansteuersignale 42 für solche weiteren Schalter.

Die Steuerungseinrichtung 40 bestimmt des Weiteren die Schaltstellung der von den aktiven Klemmschaltungen 30, 32 umfassten Schalter S5, S6. Die Steuerungseinrichtung 40 bewirkt insoweit speziell auch die Ansteuerung dieser Schalter S5, S6 mit dem oben beschriebenen anfänglichen und finalen Zeitversatz. Wenn die Verstärkerschaltung 10 bei einer entsprechenden Implementation mehr als zwei aktive Klemmschaltungen 30, 32 und entsprechend mehr als zwei davon umfasste Schalter S5, S6 aufweist, erzeugt die Steuerungseinrichtung 40 auch Ansteuersignale 42 für solche weiteren Schalter, insbesondere Ansteuersignale 42 mit einem jeweils vorgesehenen anfänglichen und finalen Zeitversatz.

Der in FIG 3 bis FIG 6 in den dortigen Zeitdiagrammen darstellte zeitliche Verlauf der Schaltzustände der von der Verstärkerschaltung 10 umfassten Schalter S1-S6 ist ein Ergebnis der Ansteuersignale 42 und eine Momentaufnahme eines Ergebnisses eines der Erzeugung der Ansteuersignale 42 zugrunde liegenden Ansteuerschemas für die Schalter S1-S6. Die Steuerungseinrichtung 40 umfasst eine Implementation dieses Ansteuerschemas zum Beispiel in Software (Steuerungsprogramm), Soft- und Firmware oder ist eine Implementation dieses Ansteuerschemas in Firmware oder Firm- und Hardware (Steuerungslogik).

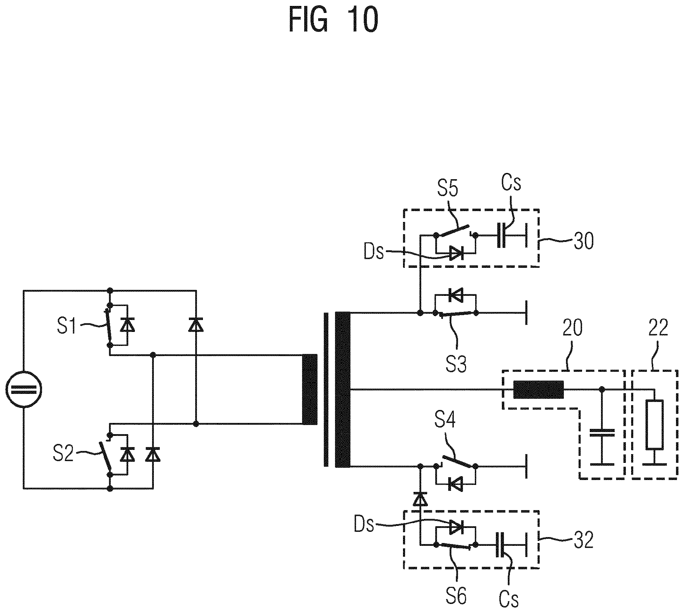

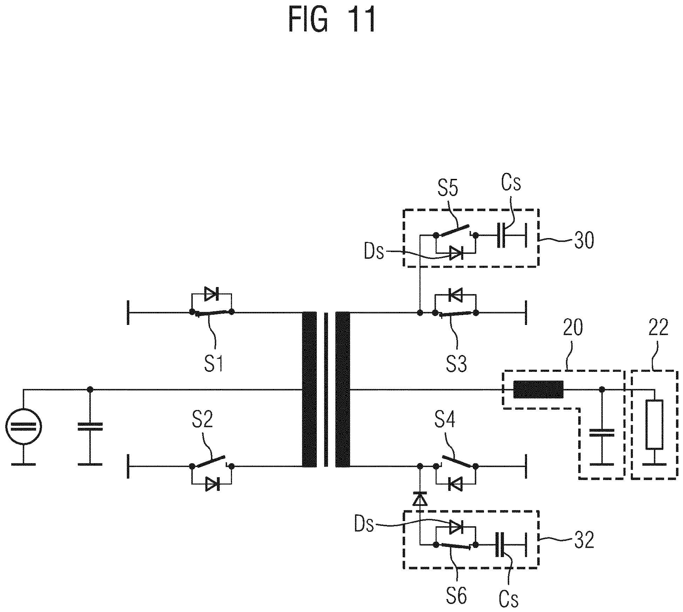

Die in FIG 3 bis FIG 6 gezeigte Verstärkerschaltung 10 - mit den unterschiedlichen Anschlussmöglichkeiten der Last 22 gemäß FIG 7 und FIG 8 - ist eine sogenannte half-brigde-forward Schaltung. Die Darstellung in FIG 9 zeigt eine Verstärkerschaltung mit auf der Ausgangsseite 16 beidseitig des Übertragers 12 und parallel zu den dortigen Schaltern S3, S4 der Ausgangsseite 16 geschalteten aktiven Klemmschaltungen 30, 32 in Form einer full-brigde-forward Schaltung. Die Darstellung in FIG 10 zeigt eine Verstärkerschaltung mit auf der Ausgangsseite 16 beidseitig des Übertragers 12 und parallel zu den dortigen Schaltern S3, S4 geschalteten aktiven Klemmschaltungen 30, 32 in Form einer two-switch-forward Schaltung und die Darstellung in FIG 11 zeigt eine Verstärkerschaltung mit auf der Ausgangsseite 16 beidseitig des Übertragers 12 und parallel zu den dortigen Schaltern S3, S4 geschalteten aktiven Klemmschaltungen 30, 32 in Form einer push-pullforward Schaltung. Die Darstellungen in FIG 9, FIG 10 und FIG 11 zusätzlich zu den Darstellungen in FIG 3 bis FIG 6 veranschaulichen die vielfältige Verwendbarkeit der hier vorgeschlagenen Neuerung. Die eingangsgenannten Vorteile ergeben sich für alle gezeigten Verstärkerschaltungsvarianten.

Auf eine Darstellung der Steuerungseinrichtung 40 und der von der Steuerungseinrichtung 40 erzeugten Ansteuersignale 42 wurde in den Darstellungen in FIG 9 bis FIG 11 jeweils verzichtet. Diese sind entsprechend der Darstellungen in FIG 3 bis FIG 6 in FIG 9 bis FIG 11 jeweils gedanklich zu ergänzen.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben werden eine Verstärkerschaltung 10 und ein Verfahren zu deren Betrieb. Die Verstärkerschaltung 10 umfasst eine Eingangsseite 14, eine Ausgangsseite 16 und einen die Eingangsseite 14 mit der Ausgangsseite 16 koppelnden Übertrager 12 sowie Schalter S1, S2 auf der Eingangsseite 14 und Schalter S3, S4 beidseitig des Übertragers 12 auf der Ausgangsseite 16. Auf der Ausgangsseite 16 weist die Verstärkerschaltung 10 beidseitig des Übertragers 12 und elektrisch parallel zu den dortigen Schaltern S3, S4 jeweils eine aktive Klemmschaltung 30, 32 auf. Bei dem Verfahren zum Betrieb einer solchen Verstärkerschaltung 10 ist der jeweilige Schalter S5, S6 jeder aktiven Klemmschaltung 30, 32 grundsätzlich offen und bei offenem Schalter S5, S6 wird elektrische Energie aus der umgebenden Verstärkerschaltung 10 in den Kondensator Cₛ der aktiven Klemmschaltung 30, 32 geladen. Im Rahmen des Verfahrens wird der Schalter S5, S6 jeder aktiven Klemmschaltung 30, 32 getaktet geschlossen und bei geschlossenem Schalter S5, S6 wird in dem Kondensator Cₛ gespeicherte elektrische Energie in die umgebende Verstärkerschaltung 10 zurückgespeist.

### Bezugszeichenliste

- 10: Verstärkerschaltung
- 12: Übertrager
- 14: Eingangsseite
- 16: Ausgangsseite
- 18: (frei)
- 20: Filter
- 22: Last
- 24: Zeitpunkt
- 26: Bereich
- 28: (frei)
- 30: (erste) aktive Klemmschaltung
- 32: (zweite) aktive Klemmschaltung
- 34-38: (frei)
- 40: Steuerungseinrichtung
- 42: Ansteuersignal

- Lₗₖ: Streuinduktivität
- S1,S2, S3, S4, S5, S6: Schalter
- R_{S}: Widerstand
- C_{S}: Kondensator
- D_{S}: Diode

## Patentansprüche

1. Verstärkerschaltung (10) mit einer Eingangsseite (14), einer Ausgangsseite (16) und einem die Eingangsseite (14) mit der Ausgangsseite (16) koppelnden Übertrager (12) sowie mit Schaltern (S1, S2) auf der Eingangsseite (14) und Schaltern (S3, S4) beidseitig des Übertragers (12) auf der Ausgangsseite (16), **dadurch gekennzeichnet,**
**dass** die Verstärkerschaltung (10) auf der Ausgangsseite (16) beidseitig des Übertragers (12) und elektrisch parallel zu den dortigen Schaltern (S3, S4) jeweils eine aktive Klemmschaltung (30, 32) aufweist.

2. Verstärkerschaltung (10) nach Anspruch 1, wobei jede aktive Klemmschaltung (30, 32) zumindest einen Schalter (S5, S6), einen Kondensator (Cₛ) und eine Diode (Dₛ) umfasst.

3. Verstärkerschaltung (10) nach Anspruch 2, wobei als Schalter (S5, S6) der aktiven Klemmschaltung (30, 32) ein MOSFET fungiert und dieser die Diode (Dₛ) als Bodydiode umfasst.

4. Verstärkerschaltung (10) nach einem der vorangehenden Ansprüche,
- wobei der Schalter (S5, S6) jeder aktiven Klemmschaltung (30, 32) grundsätzlich offen ist und bei offenem Schalter (S5, S6) elektrische Energie aus der umgebenden Verstärkerschaltung (10) in den Kondensator (Cₛ) der aktiven Klemmschaltung (30, 32) ladbar ist und
- wobei der Schalter (S5, S6) jeder aktiven Klemmschaltung (30, 32) getaktet schließbar ist und bei geschlossenem Schalter (S5, S6) in dem Kondensator (Cₛ) gespeicherte elektrische Energie in die umgebende Verstärkerschaltung (10) zurückspeisbar ist.

5. Verstärkerschaltung (10) nach einem der vorangehenden Ansprüche,
- wobei die Verstärkerschaltung (10) als aktive Klemmschaltungen (30, 32) eine erste aktive Klemmschaltung (30) und eine zweite aktive Klemmschaltung (32) aufweist,
- wobei die Verstärkerschaltung (10) beidseitig des Übertragers (12) jeweils einen Ausgangszweig, also einen ersten und einen zweiten Ausgangszweig, umfasst, welcher jeweils einen der ausgangsseitigen Schalter (S3, S4) umfasst und
- wobei die erste aktive Klemmschaltung (30) parallel zum Schalter (S3) des ersten Ausgangszweigs und die zweite aktive Klemmschaltung (32) parallel zum Schalter (S4) des zweiten Ausgangszweigs geschaltet ist.

6. Verfahren zum Betrieb einer Verstärkerschaltung (10) nach einem der vorangehenden Vorrichtungsansprüche,
- wobei der Schalter (S5, S6) jeder aktiven Klemmschaltung (30, 32) grundsätzlich offen ist und bei offenem Schalter (S5, S6) elektrische Energie aus der umgebenden Verstärkerschaltung (10) in den Kondensator (Cₛ) der aktiven Klemmschaltung (30, 32) geladen wird und
- wobei der Schalter (S5, S6) jeder aktiven Klemmschaltung (30, 32) getaktet geschlossen wird und bei geschlossenem Schalter (S5, S6) in dem Kondensator (Cₛ) gespeicherte elektrische Energie in die umgebende Verstärkerschaltung (10) zurückgespeist wird.

7. Verfahren nach Anspruch 6 zum Betrieb einer Verstärkerschaltung (10) nach Anspruch 5,
- wobei der Schalter (S5) der ersten aktiven Klemmschaltung (30) während einer Phase, während der der Schalter (S4) des zweiten Ausgangszweigs geschlossen ist, geöffnet wird und
- wobei der Schalter (S6) der zweiten aktiven Klemmschaltung (32) während einer Phase, während der der Schalter (S3) des ersten Ausgangszweigs geschlossen ist, geöffnet wird.

8. Verfahren nach Anspruch 7,
- wobei auf der Eingangsseite (14) der Verstärkerschaltung (10) in Abhängigkeit von einer Schaltstellung der dortigen Schalter (S1, S2) ein Stromfluss in Richtung auf den Übertrager (12) in einer ersten und einer entgegengesetzten zweiten Stromflussrichtung erzeugt wird,
- wobei bei einem in die erste Stromflussrichtung erzeugten eingangsseitigen Stromfluss auf der Ausgangsseite (16) der Schalter (S4) des zweiten Ausgangszweigs geschlossen wird,
- wobei bei einem in die zweite Stromflussrichtung erzeugten eingangsseitigen Stromfluss auf der Ausgangsseite (16) der Schalter (S3) des ersten Ausgangszweigs geschlossen wird,
- wobei bei einem in die erste Stromflussrichtung erzeugten eingangsseitigen Stromfluss auf der Ausgangsseite (16) der Schalter (S5) der ersten aktiven Klemmschaltung (30) geschlossen wird,
- wobei bei einem in die zweite Stromflussrichtung erzeugten eingangsseitigen Stromfluss auf der Ausgangsseite (16) der Schalter (S6) der zweiten aktiven Klemmschaltung (32) geschlossen wird.

9. Verfahren nach Anspruch 8, wobei das Schließen der Schalter (S5, S6) der ersten und zweiten aktiven Klemmschaltung (30, 32) mit einer eine jeweilige eingangsseitige Stromrichtung hervorrufenden Änderung der Schaltstellung der eingangsseitigen Schalter (S1, S2) korreliert ist und
- mit einem Zeitversatz nach der Änderung der Schaltstellung der eingangsseitigen Schalter (S1, S2) erfolgt sowie
- mit einem weiteren Zeitversatz vor einer nächstfolgenden Schaltstellung der eingangsseitigen Schalter (S1, S2) endet.

10. Computerprogramm mit Programmcodemitteln, um alle Schritte von jedem beliebigen der Ansprüche 5 bis 9 durchzuführen, wenn das Computerprogramm mittels einer von einer Verstärkerschaltung (10) nach einem der Vorrichtungsansprüche 1 bis 4 umfassten Steuerungseinrichtung (40) ausgeführt wird.

11. Computerprogrammprodukt mit elektrisch auslesbaren Steuersignalen, welche eine Ausführung eines Verfahrens nach einem der Ansprüche 5 bis 9 bewirken.

12. Verstärkerschaltung (10) nach einem der Vorrichtungsansprüche 1 bis 4 und mit zur Generierung von Ansteuersignalen (42) für die von der Verstärkerschaltung (10) umfassten Schalter (S1-S6) bestimmten Steuerungseinrichtung (40), wobei die Steuerungseinrichtung (40) beim Betrieb der Verstärkerschaltung (10) ein Verfahren nach einem der Verfahrensansprüche 5 bis 9 ausführt, ein Computerprogramm nach Anspruch 10 ausführt oder ein Computerprogrammprodukt nach Anspruch 11 als Steuerungseinrichtung (40).
